# EUROPEAN PATENT SPECIFICATION

(11) **EP 1 561 518 B1**
(45) Date of publication and mention of the grant of the patent: **05.10.2011**
(21) Application number: 03811079.7
(22) Date of filing: 07.11.2003
(51) Int. Cl.: B06B 1/06, H01L 41/08

(54) **PIEZOELECTRIC VIBRATOR, PRODUCTION METHOD THEREFOR, AND EQUIPMENT PROVIDED WITH THIS PIEZOELECTRIC VIBRATOR**
PIEZOELEKTRISCHER VIBRATOR, HERSTELLUNGSVERFAHREN DAFÜR UND MIT DIESEM PIEZOELEKTRISCHEN VIBRATOR VERSEHENE EINRICHTUNG
VIBRATEUR PIEZOELECTRIQUE, PROCEDE DE PRODUCTION ASSOCIE, ET EQUIPEMENT POURVU D'UN TEL VIBRATEUR PIEZOELECTRIQUE

(30) Priority: 12.11.2002 JP 2002328147
(43) Date of publication of application: 10.08.2005
(73) Proprietor: Seiko Epson Corporation, Shinjuku-ku Tokyo 163-0811 (JP)
(72) Inventor: SAWADA, Akihiro, c/o Seiko Epson Corporation, Suwa-shi, Nagano 392-8502 (JP); AKAHANE, Hidehiro, c/o Seiko Epson Corporation, Suwa-shi, Nagano 392-8502 (JP); NAGAHAMA, Reiko, c/o Seiko Epson Corporation, Suwa-shi, Nagano 392-8502 (JP)
(74) Representative: Cloughley, Peter Andrew
(86) International application number: PCT/JP2003/014186
(87) International publication number: WO 2004/043617

(56) References cited:
- EP-A- 1 225 644
- WO-A1-00/38309
- JP-A- 5 123 317
- JP-A- 5 193 131
- JP-A- 5 347 797
- JP-A- 2000 253 496
- JP-A- 2001 223 142
- JP-A- 2002 103 209
- JP-A- 2002 225 268
- JP-A- 2002 315 095
- US-A- 5 654 604
- US-B1- 6 361 155

## Description

### FIELD OF THE INVENTION

The present invention relates to a piezoelectric vibration body that comprises a baseboard and a piezoelectric element adhered to the baseboard, and is designed to induce vibrations in the piezoelectric element near the resonance points of a plurality of vibration modes. The present invention relates to a device using the piezoelectric vibration body.

### BACKGROUND INFORMATION

Devices in which piezoelectric elements are adhered to both sides of a tabular baseboard (reinforcing plate) to form a piezoelectric vibration body and to cause this body to operate as a piezoelectric actuator are known as so-called piezoelectric vibration bodies, which are vibrated by the displacement of the piezoelectric elements (for example, JP-A 2000-333480). In such a piezoelectric actuator, the entire piezoelectric actuator vibrates together with the baseboard, and drives a driven body when an AC voltage is applied to the piezoelectric elements. A vibration that combines a plurality of vibration modes, which include longitudinal vibrations in the lengthwise direction of the piezoelectric elements and bending vibrations in the direction orthogonal to the longitudinal vibrations, can be obtained at this time by presetting the shape and the dimensional rate. The piezoelectric actuator can thereby drive the driven body with high efficiency. In the piezoelectric actuator thus configured, the state of adhesion between the piezoelectric elements and the baseboard is very important for obtaining adequate vibrations because the baseboard is vibrated by the vibrations of the piezoelectric elements.

The vibrations of the piezoelectric elements cannot be transmitted to the baseboard in a satisfactory manner and the vibrations of the piezoelectric actuator are dampened if, for example, the adhesive layers between the piezoelectric elements and the baseboard are made excessively thick. In addition, the vibration characteristics of the plurality of piezoelectric actuators vary because different vibration dampening characteristics are obtained if there are variations in the thicknesses of the adhesive layers or the material of the adhesive agent. Thus, it is difficult to manufacture piezoelectric actuators with consistent quality due to variations in the quality of the adhesive layers.

In particular, with a piezoelectric actuator in which the resonance points of a plurality of vibration modes are brought close to each other by setting the shape or dimensions in an appropriate manner, various vibration paths such as a circular, elliptical, or other vibration path may be set by combining these vibration modes. In such a piezoelectric actuator, the driven body can be driven with maximum efficiency by causing the piezoelectric actuator to vibrate near the resonance frequency of the plurality of vibration modes. If, however, there are variations in the quality of the adhesive layers, the resonance frequency of the plurality of vibration modes varies as well. Thus, differences appear between the amplitude ratios of the vibration modes of the piezoelectric actuator at the drive frequency, and vibration characteristics vary as well.

European Patent Application published as EP 1075079 discloses a piezoelectric actuator comprising a piezoelectric vibration body, which includes a thin baseboard in the form of a reinforcing stainless-steel plate, on each side of which is disposed a piezoelectric element. The vibration body is rectangular in shape and has longitudinal and bending resonance points lying very close to each other. In use, the vibration body is excited by a driving frequency lying between these two resonance points. A projection is provided protruding in an off-centre manner from the vibration body at one end thereof. The projection acts as a driving means for driving a driven body.

EP 1225644 describes a piezoelectric device, in which a piezoelectric element is bonded onto both the front and the rear surfaces of a base master via an adhesive. The base may be of a U- or an H-shaped cross-section, and a piezoelectric element is bonded to the outer side of each of the uprights of this frame. The piezoelectric element can be bonded to an upright using a resin-series adhesive, such as epoxy resin, having a Shore D hardness of preferably not less than 80.

First object of the present invention is to provide a piezoelectric vibration body and a device using this piezoelectric vibration body in which the vibration loss can be reduced.

Second object of the present invention is to provide a piezoelectric vibration body and a device using this piezoelectric vibration body in which variation in the vibration characteristics can be reduced.

### DISCLOSURE OF THE INVENTION

The piezoelectric vibration body of the present invention has the features set forth in claim 1.

Since the adhesive layer is positioned between the base board and the piezoelectric elements, the piezoelectric element is repeatedly displaced, and thus, vibrated, when voltage is applied to the piezoelectric element at a frequency that is close to the resonance points of a plurality of vibration modes. Due to the vibration of the piezoelectric element, the baseboard is caused to vibrate as well via the adhesive layers, and the entire piezoelectric actuator vibrates along a vibration path that is a combination of the plurality of vibration modes. According to the present invention, the hardness of the adhesive layer between the baseboard and the piezoelectric element is appropriately set. Therefore, the absorption of the vibration of the piezoelectric element by the adhesive layer can be adequately prevented and the vibration can be satisfactorily transmitted to the baseboard, making it possible to allow the piezoelectric actuator to vibrate in an adequate manner. Accordingly, the vibration loss of the piezoelectric actuator can be reduced. The vibrations of the piezoelectric element will be more readily absorbed by the adhesive layer and will ultimately be dampened if the post-hardening Shore D hardness of the adhesive layer is less than 80 HS. It will therefore be impossible to reduce the vibration loss of a piezoelectric vibration body.

In the present invention, the adhesive layer is preferably composed of a one-component non-solvent type epoxy resin.

Because the adhesive layer of the present invention is preferably a one-component non-solvent type, the uniform adhesive layer can be formed without blending. In addition, air is prevented from being admixed into the adhesive layer because there is no need to perform stirring for blending purposes. When a two-component type adhesive agent that requires stirring is used and air is admixed into the adhesive layer, the air sometimes expands and damages the piezoelectric actuator when, for example, the adhesive layer are heated for hardening purposes. In addition, if an adhesive strength is inadequate because of the admixture of the air, a stress generated during vibration of the piezoelectric actuator sometimes concentrates in the air-admixed hole portions and peels off the adhesive layer. Thus, the service life of the piezoelectric actuator is reduced. This drawback is overcome, and variation in the quality of the adhesive layer from different lots is less likely to occur in the present invention. This results in uniform adhesion between the baseboard and the piezoelectric element. Thus, variation in the amplitude ratio among a plurality of vibration modes is reduced even when the piezoelectric actuator is caused to vibrate near the resonance points of the plurality of vibration modes. Variation in the vibration characteristics among various piezoelectric actuators is thereby reduced, and the desired vibration path is obtained. Thus, the second object of the present invention can be achieved. Furthermore, mixing operations are eliminated, resulting in relatively inexpensive production.

A manufacturing method of a piezoelectric vibration body in which resonance points of a plurality of vibration modes are close to each other, comprising a baseboard and a piezoelectric element adhered to one side of the baseboard, is characterized in including an adhesive layer formation step for forming an adhesive agent into an adhesive layer with a prescribed thickness that is positioned between the baseboard and the piezoelectric element, an adhesive layer transferring step for transferring the adhesive layer formed in the adhesive layer formation step on the piezoelectric element, and a piezoelectric element adhering step for adhering the piezoelectric element on which the adhesive layer is transferred on the baseboard or an additional piezoelectric element.

The adhesive layer with a uniform thickness of the adhesive agent is formed by the adhesive layer formation step. The piezoelectric actuator with the adhesive layer with a uniform thickness can be manufactured by transferring the adhesive layer to the piezoelectric element, and adhering the piezoelectric element to the baseboard. Variation in the vibration characteristics of the piezoelectric actuator can thereby be reduced.

The adhesive layer formation step preferably includes an adhesive layer thickness adjusting step for transferring the adhesive layer on a thickness adjustment transferring member and adjusting a thickness of the adhesive layer by changing a number of transfers.

In the adhesive layer thickness adjustment step, for example, the adhesive layer formed in the adhesive layer formation step is transferred to a thickness-adjusting transfer member, then, the thickness of the adhesive layer is about half the thickness before the transfer. The thickness of the adhesive layer can be brought to the desired level by repeating the transfers to the thickness-adjusting transfer member. Consequently, the adhesive layer thickness adjustment step is particularly useful in forming thinner adhesive layers, whose thickness is difficult to control, in the adhesive layer formation step. Thus, the thickness of the adhesive layers can be controlled with greater ease, and thinner adhesive layers can be formed.

An adhesive layer hardening step is preferably provided for hardening the adhesive layer by applying heat and pressure on the adhesive layer after the piezoelectric element adhering step.

Since the adhesive layer is hardened under the heated condition, the hardening of the adhesive layer occurs in a short period of time and the time required to manufacture the piezoelectric vibration body is reduced.

Also, since the adhesive layer is hardened under the pressurized condition, the adhesive strength between the baseboard and the piezoelectric element is improved.

Moreover, the baseboard and the piezoelectric element are compression bonded in a pressed state, and the surfaces of contact between surfaces of the baseboard and the piezoelectric element are provided with irregularities that correspond to each surface roughness on a microscopic scale, and these irregularities are brought into contact with each other by the applied pressure, ensuring conductivity between the two. The adhesive layer is thereby interposed between these irregularities, and the thickness of the adhesive layer depends on the surface roughness of the piezoelectric element and the baseboard as a result. Consequently, it becomes possible to easily control the thickness of the adhesive layer by using the surface roughness of the contact between the baseboard and the piezoelectric element. Thus, the variation in the thickness of the adhesive layer is reduced, and the vibration characteristics of the piezoelectric actuator are further stabilized. When the baseboard is composed of a conductive material, good contact is maintained with the electrode layer formed on the piezoelectric element, ensuring electrical conductivity between the two. As a result, it becomes possible to obtain one of the terminals from the baseboard when voltage is applied in the thickness direction of the piezoelectric elements. Thus, when the piezoelectric elements are adhered on both sides of the baseboard, the baseboard can be used as a shared terminal, and the structure of the piezoelectric actuator can be simplified.

A surface coarseness adjusting step is preferably provided for adjusting a coarseness of a surface of the baseboard on which the piezoelectric element is adhered prior to the piezoelectric element adhering step.

The roughness of the adherence surfaces of the piezoelectric element on the baseboard is adjusted in the adherence roughness adjusting step. Thus, any burrs produced in the manufacturing steps of the baseboard can be removed, and deterioration of the vibration characteristic of the piezoelectric vibration body due to the burrs can be prevented.

In addition, the roughness of the adherence surfaces of the piezoelectric element on the baseboard is appropriately adjusted in advance. Thus, the adhering strength of the adhesive layer is improved and the peel strength is improved.

Moreover, as explained above, since the thickness of the adhesive layer depends on the surface roughness of the baseboard and the piezoelectric element, the thickness of the adhesive layer can be controlled by coordinating the surface roughness of the baseboard. Thus, it is possible to further reduce the thickness variation of the adhesive layer and to reduce any variation in the vibration characteristics of the piezoelectric actuator.

A positioning step is preferably provided for aligning the baseboard and the piezoelectric element with respect to each other simultaneously with or after the piezoelectric element adhering step.

Since the relative positions of the baseboard and the piezoelectric element are established in the positioning step, if the adhesive layer is hardened under such condition, it is possible to prevent these relative positions from becoming misaligned in the adhesive layer hardening step. It is therefore possible to reduce the variation caused by such positional misalignments in the vibration characteristics of the piezoelectric actuator by this step.

The baseboard and the piezoelectric element preferably have substantially the same thermal expansion coefficient.

Strain and residual stress can be prevented from being induced by the effect of heat because the coefficients of thermal expansion of the baseboard and the piezoelectric element are kept close to each other. This is particularly useful in cases in which, for example, heating is conducted during hardening of the adhesive layers. In addition, any degradation of characteristics induced by self-heating can be suppressed even in cases in which the supply of power is increased and the amount of generated heat exceeds the amount of radiated heat.

In the present invention, a device is characterized in utilizing the piezoelectric vibration body as mentioned above, or manufactured by the method for manufacturing the piezoelectric vibration body as mentioned above.

In accordance with the present invention, since the device utilizes the piezoelectric vibration body of the present invention or the piezoelectric vibration body that is manufactured in accordance with the above manufacturing method, the above mentioned effects can be obtained. The vibration loss can be reduced and a variation in the vibration characteristics among various piezoelectric actuators is thereby reduced.

### BRIEF DESCRIPTION OF THE DRAWINGS

FIG. 1 is an overall perspective view of a piezoelectric vibration body in accordance with the present invention;
FIG. 2 is an enlarged cross-sectional view depicting a part of the piezoelectric vibration body in accordance with the present invention;
FIG. 3 is a schematic view depicting an adhesive layer formation step of the piezoelectric vibration body in accordance with the present invention;
FIG. 4 is a schematic view depicting an adhesive layer transferring step of the piezoelectric vibration body in accordance with the present invention;
FIG. 5 is a schematic view depicting a piezoelectric element adhering step of the piezoelectric vibration body in accordance with the present invention;
FIG. 6 is a schematic view depicting an adhesive layer hardening step of the piezoelectric vibration body in accordance with the present invention;
FIG. 7 is a schematic view depicting a positioning step of the piezoelectric vibration body in accordance with the present invention;
FIG. 8 is a schematic view depicting an application example of the piezoelectric vibration body in accordance with the present invention;
FIG. 9 is a schematic view depicting the operation of the piezoelectric vibration body in accordance with the present invention;
FIG. 10 is a diagram depicting the relation between the Shore D hardness of an adhesive layer and a Q-value of the piezoelectric vibration body in accordance with the present invention;
FIG. 11 is a diagram depicting the relation between an amplitude near the resonance points and the Q-value of the piezoelectric vibration body in accordance with the present invention;
FIG. 12 is a diagram depicting the vibration characteristics of the piezoelectric vibration body based on differences in the Q-value;
FIG. 13 is a diagram depicting the vibration behavior of the piezoelectric vibration body based on differences in the Q-value; and
FIG. 14 is a schematic view depicting an alternate example of an adhesive layer formation step in accordance with the present invention.

### DESCRIPTION OF THE PREFERRED EMBODIMENTS

Selected embodiment of the present invention will now be explained with reference to the drawings.

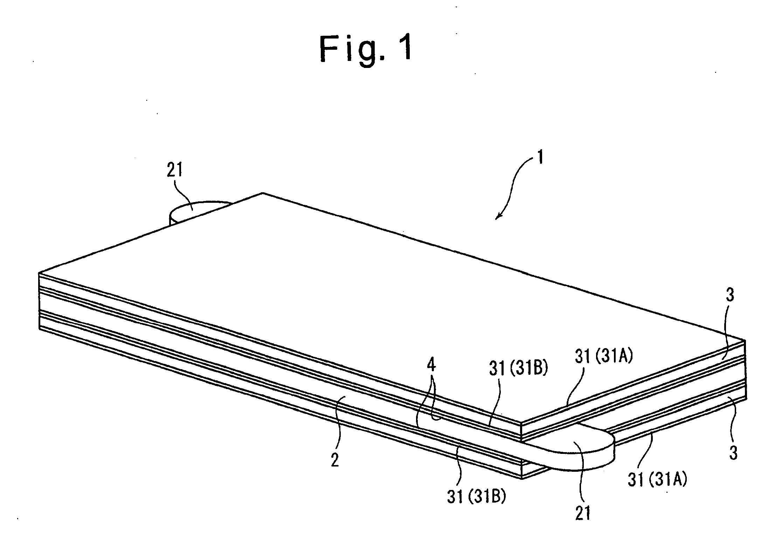

FIG. 1 depicts an overall perspective view of a piezoelectric actuator 1 as a piezoelectric vibration body of the present embodiment. In FIG. 1, the piezoelectric actuator 1 comprises a tabular baseboard 2, a pair of piezoelectric elements 3 adhered to the front and back sides of the baseboard 2, and a pair of adhesive layers 4 that couple the baseboard 2 to the piezoelectric elements 3.

The baseboard 2 is a thin-plate member with a thickness of about 0.1 mm formed into a substantially rectangular shape. The material of the baseboard 2 can be stainless steel, phosphor bronze, or another arbitrary material. In the present embodiment, the material of the baseboard 2 is SUS301. Substantially semicircular projections 21 that protrude in the lengthwise direction are integrally formed on the two diagonal ends of the baseboard 2.

The piezoelectric elements 3 are adhered to the substantially rectangular portion of the baseboard 2, with the exception of the projections 21. The material of the piezoelectric elements 3 is not limited in any particular way and can be lead titanate zirconate (PZT^{®}), crystal, titanium niobate, or the like. Lead titanate zirconate (abbreviated as "PZT" hereinbelow) with a thickness of about 0.15 mm is preferably used in the present embodiment. Electrode layers 31 (31A, 31B) formed from nickel/phosphorus plated layers or gold plated layers, etc., are also formed on both sides of the piezoelectric elements 3.

The adhesive layers 4 are composed of a one-component non-solvent type epoxy resin with a post-hardening Shore D hardness of about 92 HS. The adhesive layers 4 preferably contains no colorants, glass beads, electroconductive substances, or other additives.

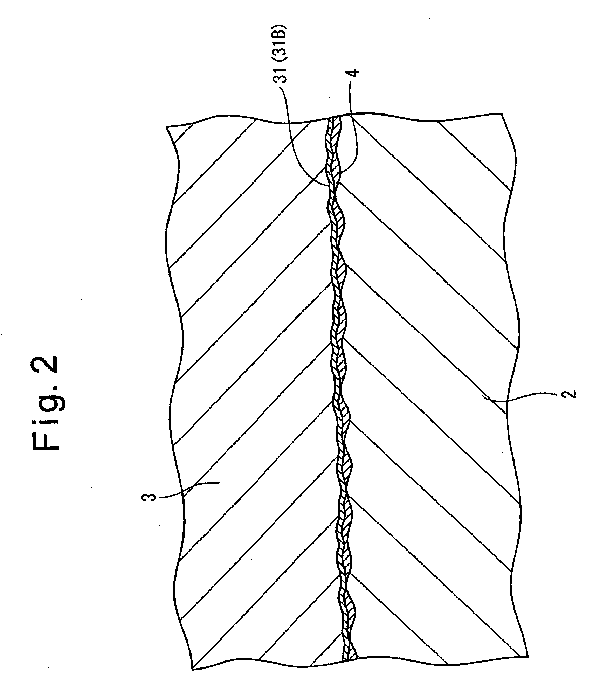

FIG. 2 is an enlarged cross-sectional view of part of an adhesion surface between the baseboard 2 and the piezoelectric elements 3. In FIG. 2, each of the adhesion surfaces between the baseboard 2 and the piezoelectric elements 3 has minute irregularities that correspond to each surface roughness on a microscopic scale. Random contact of these irregularities allows the baseboard 2 and the electrode layers 31B of the piezoelectric elements 3 to form an electroconductive path without being insulated by the adhesive layers 4. Voltage can thereby be applied between the baseboard 2 and the electrode layers 31A of the piezoelectric elements 3, that is, between the two sides of the piezoelectric elements 3, by connecting a lead wire to the baseboard 2 and the electrode layers 31A on the surfaces of the piezoelectric elements 3, and connecting this wire to an application device (not shown).

The piezoelectric actuator 1 is manufactured in the following manner.

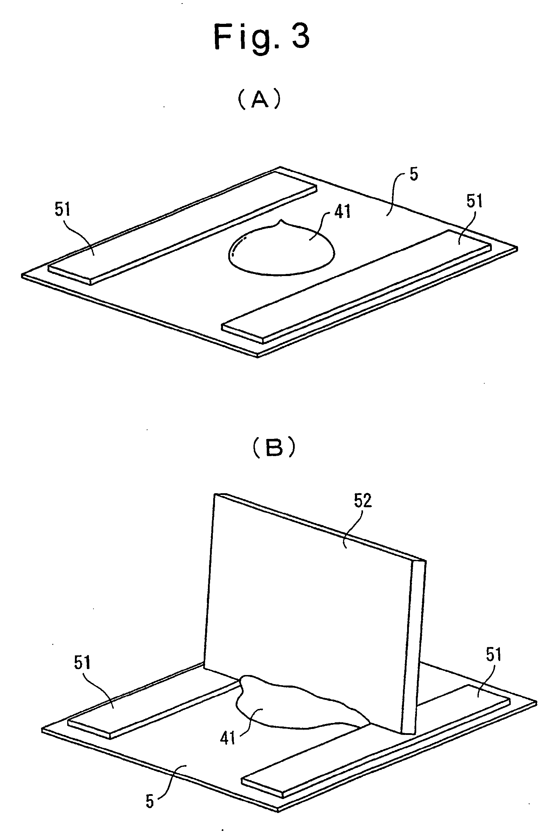

FIGS. 3 to 7 are diagrams depicting the steps for manufacturing the piezoelectric actuator 1. As shown in FIGS. 3 to 7, the steps for manufacturing the piezoelectric actuator 1 comprise an adhesive layer formation step for forming an adhesive agent 41 (refer to FIG. 3) into the adhesive layer 4 with a prescribed thickness, an adhesive layer transfer step for transferring the adhesive layer 4 formed in the adhesive layer formation step on the piezoelectric element 3, a surface roughness adjustment step for adjusting the surface roughness of the adherend surface of the baseboard 2 along which the piezoelectric element 3 is adhered, a piezoelectric element adherence step for adhering the piezoelectric element 3 with the transferred adhesive layer 4 to the baseboard 2, and an adhesive layer hardening step for hardening the adhesive layer 4. With the exception of the adhesive layer hardening step, all the steps are performed at room temperature.

FIG. 3(A) depicts the first stage of the adhesive layer formation step, and FIG. 3(B) depicts the second stage thereof. In FIG. 3(A), two spacers 51 shaped as thin-plate rectangles are first placed at a distance from each other on a transfer sheet 5 on a silicon wafer (not shown) in the first stage of the adhesive layer formation step. At this time, the surface of the silicon wafer is wiped with cotton impregnated with ethanol, and the transfer sheet 5 is mounted on the silicon wafer before the ethanol vaporizes. With this arrangement, the transfer sheet 5 adequately adheres to the surface of the silicon wafer and is securely bonded to the silicon wafer by sticking as ethanol vaporizes. The warping of the transfer sheet 5 is corrected and the thickness of the adhesive layer 4 formed on the transfer sheet 5 becomes uniform because the silicon wafer has a very smooth flat surface. The material of the transfer sheet 5 is preferably a flexible material such as a polyimide, polyester, or the like. In addition, the spacers 51 have about twice the thickness of the adhesive layer 4 interposed on the piezoelectric actuator 1. The material of the spacers 51 is preferably one that resists deformation in the thickness direction such as aluminum foil with a thickness of about 10 µm or the like.

The adhesive agent 41 is subsequently ejected in an appropriate amount between the two spacers 51. The dimensions of the transfer sheet 5 and the spacers 51, the positioning interval between the spacers 51, and the like should be appropriately set with consideration for the dimensions of the piezoelectric actuator 1 to be manufactured. For example, the dimensions and the interval should be set greater than the dimensions of the piezoelectric actuator 1, and when a plurality of piezoelectric actuators 1 is manufactured at once, these parameters should be set greater than the overall dimensions when the plurality of piezoelectric actuators 1 is mounted.

In the second stage of the adhesive layer formation step, a flat blade 52 made of stainless steel, glass, or another rigid material is pressed against the two spacers 51 while positioned to span the spacers 51, as shown in FIG. 3(B). In this case, the adhesive agent 41 spreads between the spacers 51 in the width direction along the blade 52. The blade 52 is subsequently moved over the two spacers 51 in the lengthwise direction thereof.

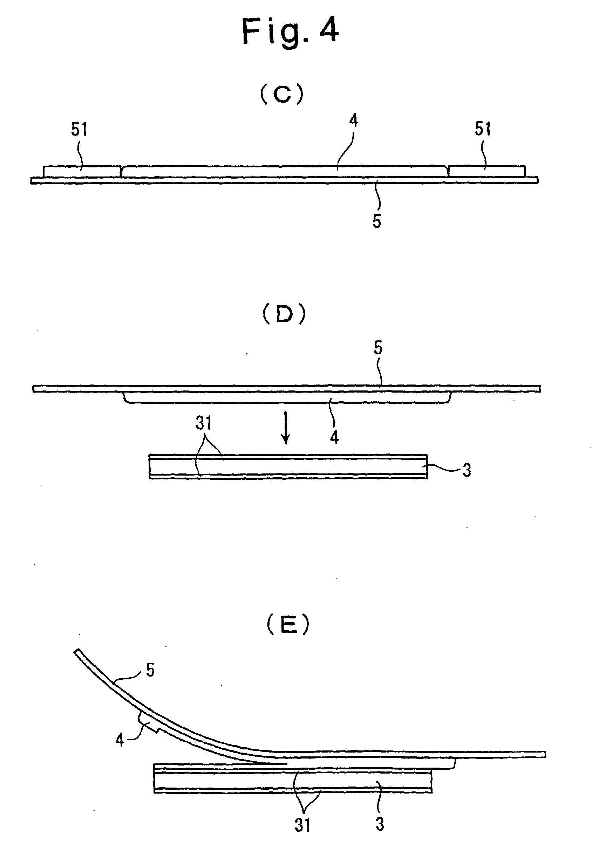

FIG. 4(C) depicts an adhesive layer 4 formed on the transfer sheet 5. As shown in FIG. 4(C), the adhesive agent 41 is adjusted to have the thickness of the spacers 51 while being spread between the spacers 51 with the blade 52. The spacers 51 are subsequently removed from the transfer sheet 5. By means of this step, the adhesive layer 4 is formed in the thickness of the spacers 51 on the transfer sheet 5.

The adhesive layer 4 formed in the adhesive layer formation step is subsequently transferred to the piezoelectric element 3 in the adhesive layer transfer step.

FIGS. 4(D) and 4(E) are schematic views of the adhesive layer transfer step. In FIG. 4(D), the surface of the transfer sheet 5 on which the adhesive layer 4 has been formed is placed opposite the piezoelectric element 3. In the case shown, electrode layers 31 are formed in advance on the front and back sides of the piezoelectric element 3. The electrode layers 31 are formed by a process in which the two sides of the piezoelectric element 3 are adjusted to a mean surface roughness (Ra) of about 0.2 µm to about 0.3 µm with a 2000 grit abrasive material and electroless gold plating is performed using nickel/phosphorus plating (Ni/P) as the underlayer. Electrode layers 31 with a thickness of about 1 µm are thereby formed on the front and back sides of the piezoelectric element 3. The material used in adjusting the surface roughness of the piezoelectric element 3 is not limited to the 2000 grit abrasive material. For example, a 4000 grit abrasive material or other suitable material may be appropriately selected when the surface roughness of the piezoelectric element 3 is adjusted. Also, the method for forming the electrode layers 31 is not limited to methods based on such electroless gold plating. For example, a Ni-Cr-Au alloy may be formed on the surfaces of the piezoelectric element 3 by sputtering, vapor deposition, or the like.

The piezoelectric element 3 whose surfaces have been provided with the electrode layers 31 is pre-washed in order to remove microscopic contaminants. In the washing step, the piezoelectric element 3 is ultrasonically washed with alcohol for about 10 minutes, and the piezoelectric element 3 is then washed with purified running water for about 10 minutes. The piezoelectric element 3 is then dried by being allowed to stand for about 10 minutes in a thermostat kept at approximately 80°C. The piezoelectric element 3 thus washed is placed and fixed on an attachment table. The surface of the transfer sheet 5 with the adhesive layer 4 is then bonded to the surface of the fixed piezoelectric element 3.

The transfer sheet 5 is then slowly peeled off from the piezoelectric element 3, as shown in FIG. 4(E). About half the thickness of the adhesive layer 4 is transferred to the piezoelectric element 3, and the adhesive layer 4 with about the remaining half of the thickness is left behind on the transfer sheet 5.

As a result of the adhesive layer transfer step, an adhesive layer 4 is formed on the piezoelectric element 3, and the thickness of the layer is about 5 µm, which is approximately half the thickness of the adhesive layer 4 in the adhesive layer formation step.

The piezoelectric element 3 with the transferred adhesive layer 4 is then adhered to the baseboard 2 by using a piezoelectric element adherence step.

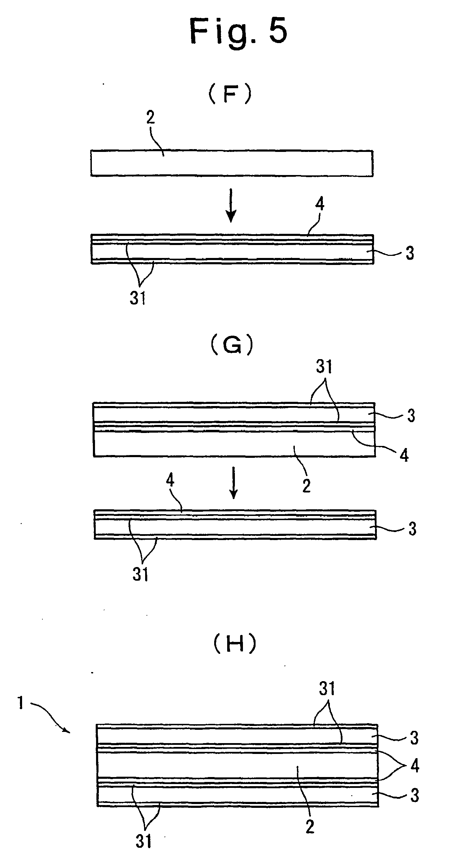

FIG. 5(F) depicts the step in which the piezoelectric element 3 is adhered to one side of the baseboard 2, and FIG. 5(G) depicts the step in which the piezoelectric element 3 is adhered to the opposite side of the baseboard 2.

The side of the piezoelectric element 3 onto which the adhesive layer 4 has been transferred is adhered to the substantially rectangular portion of the baseboard 2, as shown in FIG. 5(F). It is visually confirmed at this time that there is no misalignment between the relative positions of the piezoelectric element 3 and the baseboard 2. Surface roughness is adjusted in advance on both sides of the baseboard 2 by using a surface roughness adjustment step. In the surface roughness adjustment step, the surfaces are adjusted to a prescribed surface roughness with 1500 grit sandpaper, for example. The baseboard 2 is washed in advance by using the same step as the above-described washing step of the piezoelectric element 3.

The piezoelectric element 3 is adhered in the same manner on the opposite side from the side of the baseboard 2 on which the first piezoelectric element 3 is adhered, as shown in FIG. 5(G).

FIG. 5(H) depicts the piezoelectric actuator 1 obtained by adhering the piezoelectric elements 3 on both sides of the baseboard 2. As shown in FIG. 5(H), the piezoelectric elements 3 are adhered via the adhesive layers 4 on both sides of the baseboard 2 in the piezoelectric element adherence step.

Then, the adhesive layers 4 are hardened in the adhesive layer hardening step.

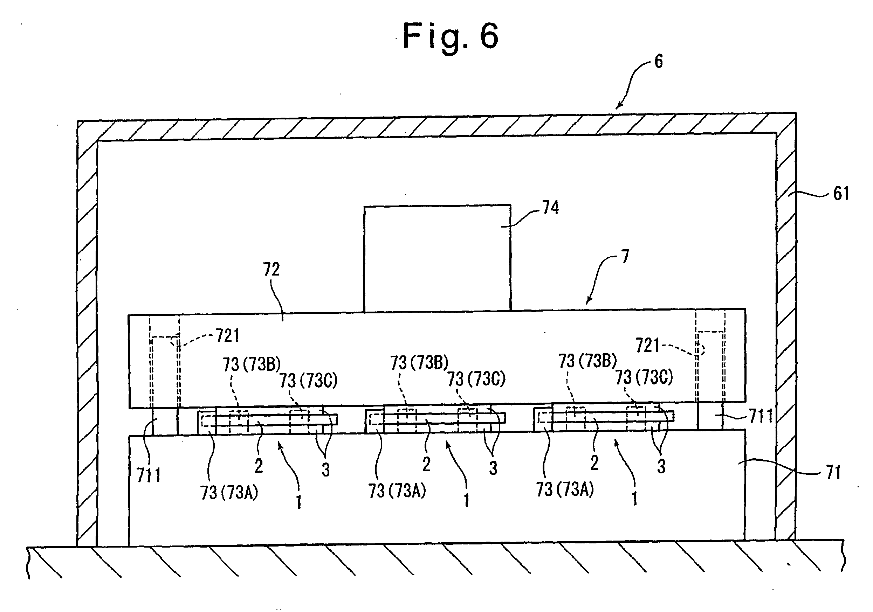

FIG. 6 is a schematic view of a hardening device 6 whereby the adhesive layers 4 are caused to harden under heat and pressure. The hardening device 6 in FIG. 6 comprises a heating tank 61 for heating the interior to a prescribed temperature, and a pressure tool 7 for applying pressure to the piezoelectric elements 3 and the baseboard 2 of the piezoelectric actuator 1. The pressure tool 7 comprises a bottom plate 71 and a top plate 72, with the piezoelectric actuator 1 held therebetween. Four pins 711 protrude toward the top plate 72 along the periphery of the bottom plate 71. Guide holes 721 are formed in the top plate 72 at positions that correspond to the pins 711. The position of the top plate 72 in relation to the bottom plate 71 is established by passing the pins 711 through the guide holes 721.

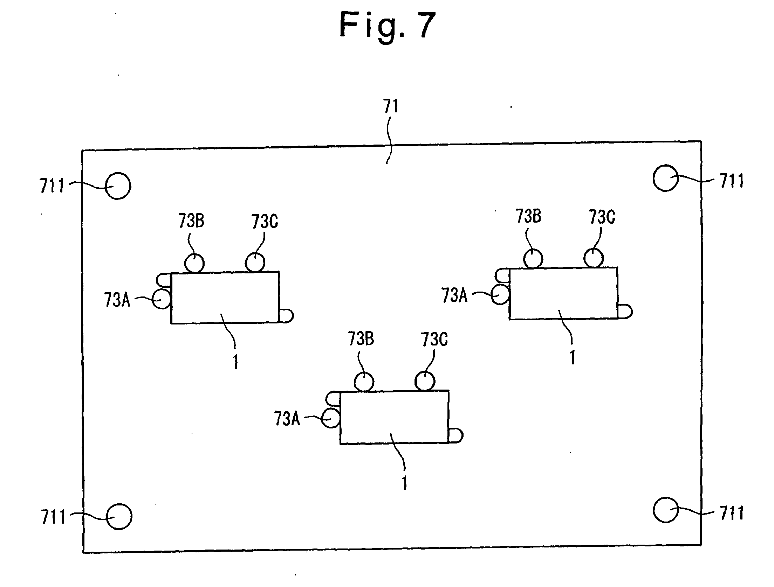

FIG. 7 is a plan view of the bottom plate 71. In FIG. 7, the bottom plate 71 is provided with columnar alignment or positioning pins 73 that allow three piezoelectric actuators 1 to be mounted at positions not aligned in a straight line and that align the relative positions of the baseboard 2 and the piezoelectric elements 3. A plurality (three in the present embodiment) of these positioning pins 73 (73A, 73B, 73C) is provided to each piezoelectric actuator 1. The positioning pins 73 are disposed at prescribed intervals from each other, and the positioning pin 73A disposed at the ends are located at positions that are offset from the extension of the line connecting the other positioning pins 73B and 73C. The three positioning pins 73A, 73B, and 73C ensure stable alignment by supporting the piezoelectric actuators 1 on two sides. The surfaces of the positioning pins 73 are coated with polytetrafluoroethylene or another low-friction synthetic resin in order to prevent adhesion with the adhesive layers 4. Also, the height of the positioning pins 73 is greater than the combined thickness of a single piezoelectric element 3 and the baseboard 2, but less than the combined thickness of two piezoelectric elements 3 and the baseboard 2. In the present embodiment, the positioning pins 73 are provided with a columnar shape in order to minimize the surface area of contact with the adhesive layers 4, although it is also possible, for example, to fashion the pins into triangular poles or other polygonal poles.

The relative position of the baseboard 2 and piezoelectric elements 3 is established by using an alignment or positioning step that precedes the adhesive layer hardening step. In the positioning step, each of the three piezoelectric actuators 1 obtained by adhering piezoelectric elements 3 on two sides of the baseboard 2 in the piezoelectric element adherence step is mounted on the bottom plate 71 of the pressure tool 7. At this time, a magnifying mirror or the like is used to confirm that the end positions of the piezoelectric elements 3 and the baseboard 2 have been aligned by bringing the two sides of the piezoelectric actuator 1 into contact with the positioning pins 73. In the case of a misalignment, the piezoelectric elements 3 are held with tweezers or the like and the position is corrected.

The top plate 72 is subsequently placed on the piezoelectric actuators 1 disposed in the established positions. Since the top plate 72 is guided by the pins 711 and kept substantially parallel to the bottom plate 71, the top plate 72 is brought into contact with, and mounted on, the piezoelectric actuators 1 while successive confirmations are performed to ensure that the relative positions of the piezoelectric elements 3 and the baseboard 2 have not become misaligned. At this time, since the thickness of the positioning pins 73 is less than the thickness of the piezoelectric actuators 1, the top plate 72 comes into contact with the surfaces of the piezoelectric actuators 1 without interfering with the positioning pins 73.

The pressure tool 7 with the piezoelectric actuators 1 thus held therein is mounted in the heating tank 61. A weight 74 for applying pressure to the piezoelectric actuators 1 is placed on the top plate 72. Since three piezoelectric actuators 1 are disposed between the top plate 72 and the bottom plate 71 so as not to be aligned in a straight line, the top plate 72 is kept in uniform contact with the piezoelectric actuators 1. Thus, the surface pressure (relative pressure) applied to each of the piezoelectric actuators 1 is substantially the same. The weight 74 preferably maintains the surface pressure applied to the piezoelectric actuators 1 within a range of 15 to 25 gf/mm² (147 to 245 kPa). The bonding between the piezoelectric elements 3 and the baseboard 2 is adversely affected if the surface pressure is less than 15 gf/mm² (147 kPa). In addition, the adhesive layers 4 become thicker and the vibration characteristics of the piezoelectric actuators 1 deteriorate, or the conductivity between the baseboard 2 and the electrode layers 31B of the piezoelectric elements 3 is adversely affected. Moreover, the vibration characteristics of the piezoelectric actuators 1 are caused to vary due to variation in the thickness of the adhesive layers 4. Furthermore, it is possible that the piezoelectric elements 3 will be damaged if the surface pressure exceeds 25 gf/mm² (245 kPa). In the present embodiment, a 1-kg weight 74 is used in order to apply pressure to the three piezoelectric actuators 1.

The adhesive layers 4 are hardened by setting the temperature inside the heating tank 61 to about 80°C and heating the piezoelectric actuators 1 inside the heating tank 61 for about 2 hours while applying pressure with the pressure tool 7.

In this adhesive layer hardening step, the bonding between the piezoelectric elements 3 and the baseboard 2 is improved by performing hardening in a pressed state. At this time, the surfaces of contact between the baseboard 2 and the electrode layers 31 formed on the piezoelectric elements 3 are provided with irregularities that correspond to each surface roughness on a microscopic scale, and these irregularities are brought into contact with each other by the applied pressure, ensuring conductivity between the two. Specifically, the mutual microscopic irregularities on the piezoelectric elements 3 and the baseboard 2 are kept in a state of contact across the entire surface of adhesion. Thus, the thickness of the adhesive layers 4 depends on the surface roughness of the piezoelectric elements 3 and the baseboard 2 as a result.

In addition, by hardening the adhesive layers 4 in a heated state, the adhesive layers 4 can be hardened in a short time, and the cycle time of the adhesive layer hardening step can be reduced.

In the piezoelectric actuator 1 thus manufactured, a driven body can be driven by bringing the projections 21 into contact with the driven body and causing the piezoelectric elements 3 to vibrate.

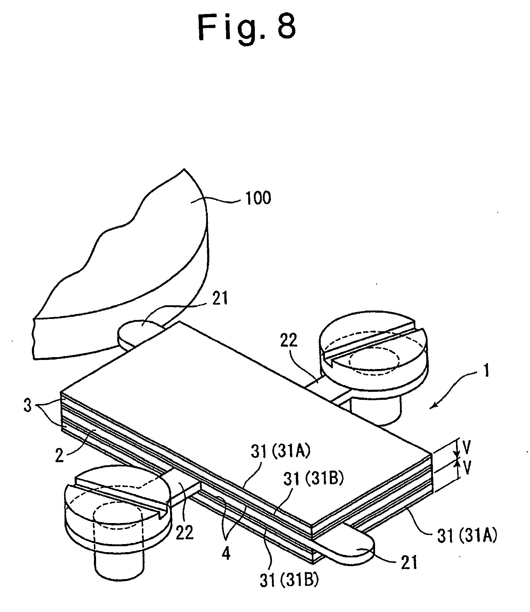

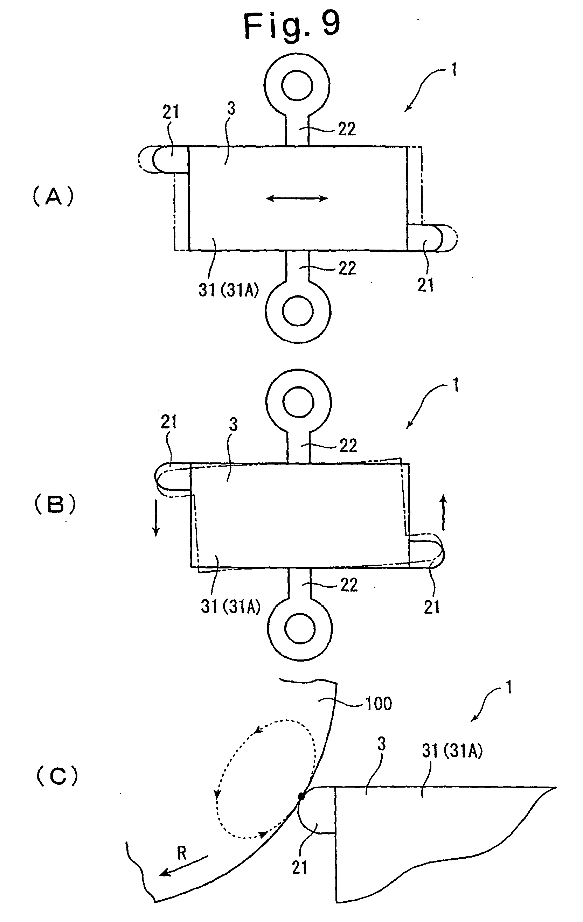

FIGS. 8 and 9 are schematic views depicting examples of the piezoelectric actuator 1. FIG. 8 is a diagram depicting the position of the piezoelectric actuator 1 in relation to a driven body 100. FIG. 9(A) is a diagram depicting one of the vibration modes of the piezoelectric actuator 1. FIG. 9(B) is a diagram depicting another vibration mode of the piezoelectric actuator 1. FIG. 9(C) is a diagram depicting the path described by the projection 21.

First, in FIG. 8, the piezoelectric actuator 1 drives a disk-shaped driven body 100, and the driven body 100 is rotatably held by a supporting member (not shown). The projection 21 of the piezoelectric actuator 1 presses against the external peripheral surface of the driven body 100. Arms 22 that protrude substantially at a right angle from the approximate center of the lengthwise direction are provided on both sides of the piezoelectric actuator 1. These arms 22 are formed integrally with the baseboard 2. The piezoelectric actuator 1 are fixed in place by threadably engaging holes formed in the end portions of the arms 22 with the support member (not shown). The projection 21 is pressed against the driven body 100 in a state in which an appropriate urging force is applied with the aid of urging force generation means (not shown). At this time, the projection 21 is pressed against the driven body 100 such that the lengthwise direction of the piezoelectric actuator 1 is at a certain angle (for example, 30°) with respect to the center direction of the driven body. Lead wires are connected to the baseboard 2 and the electrode layers 31A of the piezoelectric elements 3, and these lead wires are connected to an application device for applying an AC voltage of a prescribed frequency.

Applying an AC voltage V between the electrode layers 31 A and the baseboard 2 by the application device causes the piezoelectric element 3 disposed therebetween to be repeatedly displaced and vibrated. At this time, the piezoelectric actuator 1 has two vibration modes: so-called longitudinal vibrations, in which longitudinal expansions and contractions occur as shown in FIG. 9(A); and so-called bending vibrations, in which bending occurs in the direction substantially orthogonal to the longitudinal vibrations, as shown in FIG. 9(B). A combination of these two vibration modes causes the projection 21 to vibrate while scribing an elliptical path within a single plane, as shown in FIG. 9(C). The two vibration modes referred to herein have individual resonance points, and the difference between the resonance frequencies of these resonance points is set in advance to a value, approximately several kilohertz, at which the two points remain close to each other. This is achieved by selecting appropriate settings for the dimensions or shape of the piezoelectric actuator 1. The result is that if the piezoelectric actuator 1 is driven between these resonance frequencies, the drive can occur near the resonance points of the two vibration modes, making it possible to obtain a wide vibration amplitude for each.

The projection 21 causes the driven body 100 to rotate in the direction of arrow R in FIG. 9(C) along a portion of the elliptical path. The piezoelectric actuator 1 causes the driven body 100 to rotate at the desired speed by performing this operation with a prescribed frequency.

The relation between the Shore D hardness of the adhesive layers 4 and the vibration behavior of the piezoelectric actuator 1 in the piezoelectric actuator 1 of the present embodiment will now be described.

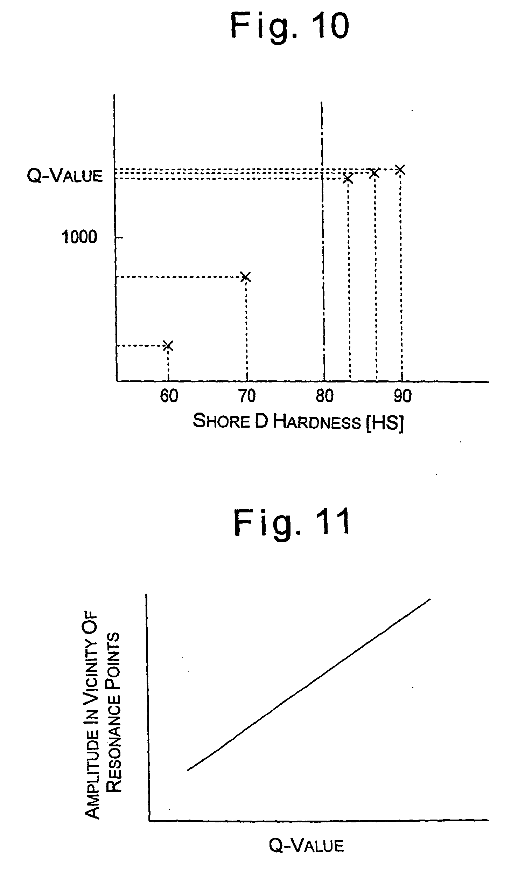

FIG. 10 depicts the relation between the post-hardening Shore D hardness of the adhesive layers 4 and the Q-value of the piezoelectric actuator 1. It can be seen that an increase in the Shore D hardness of the adhesive layers 4 causes the Q-value of the piezoelectric actuator 1 to increase rapidly. A high Q-value of 1000 or greater is obtained in a stable manner at a Shore D hardness of 80 HS or greater, as shown in FIG. 10.

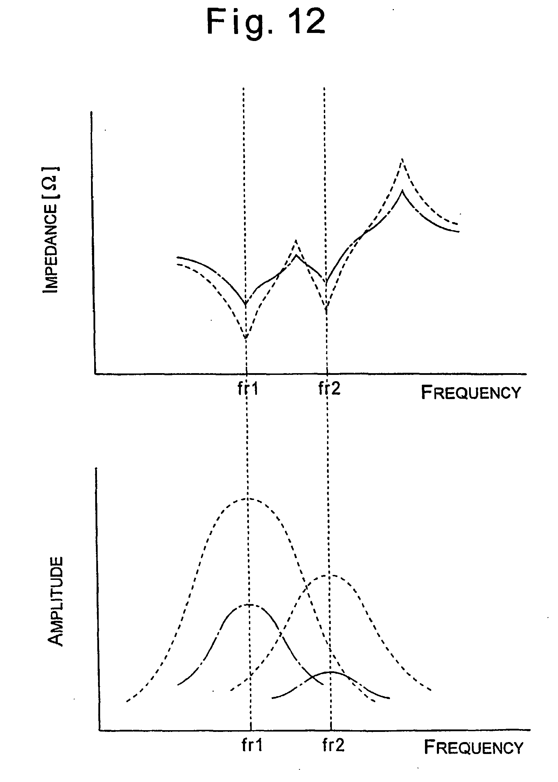

Next, FIG. 11 depicts the relation between the Q-value of the piezoelectric actuator 1 and the amplitude of vibration near the resonance points of the piezoelectric actuator 1. Furthermore, FIG. 12 depicts a diagram of the relation between impedance and the frequency of the voltage applied to the piezoelectric actuator 1, and also depicts a diagram of the relation between the frequency and the amplitude of the piezoelectric actuator 1. In FIG. 12, fr1 is the resonance frequency of longitudinal vibrations, and fr2 is the resonance frequency of bending vibrations.

First, it can be seen that the amplitude near the resonance points of the piezoelectric actuator 1 is directly proportional to the Q-value and that the amplitude of the piezoelectric actuator 1 increases with an increase in the Q-value, as shown in FIG. 11. It can also be seen that the impedances at the resonance points of the two vibration modes (longitudinal vibrations and bending vibrations) are lower, and the amplitudes of these vibration modes are wider, for vibration characteristics (dotted line in FIG. 12) with a comparatively high Q-value of the piezoelectric actuator 1 than for vibration characteristics (dashed line in FIG. 12) with a comparatively low Q-value, as shown in FIG. 12.

Based on these facts, it can be seen that a high Q-value can be obtained by the use of a high-hardness adhesive layer 4 with a Shore D hardness of 80 HS or greater. It can also be seen that the vibration loss of the piezoelectric actuator 1 can be reduced and wide vibration amplitude can be obtained in the piezoelectric actuator 1 by obtaining a high Q-value.

Here, the amplitude of the longitudinal vibrations of the piezoelectric actuator 1 increases with increased Q-value. On the other hand, the amplitude of the bending vibrations of the piezoelectric actuator 1 depends on the Q-value as well in the same manner as in the case of longitudinal vibrations. There is also the element of the bending vibrations being excited by the longitudinal vibrations. Consequently, the amplitude of the longitudinal vibrations must be maintained in some measure in order to maintain the amplitude of the bending vibrations.

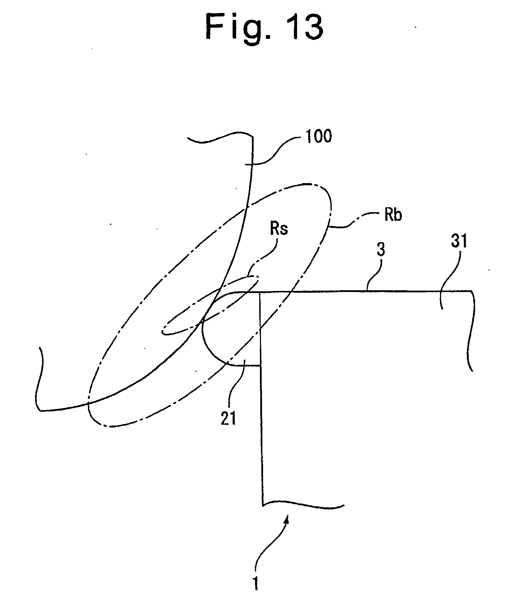

FIG. 13 depicts the vibration paths followed by a projection 21 of the piezoelectric actuator 1 in a case in which the Q-value of the piezoelectric actuator 1 is comparatively low, and in a case in which the Q-value is comparatively high. In FIG. 13, the vibration loss is high and the amplitude of longitudinal vibrations is narrow when the Q-value is low, that is, when the Shore D hardness of the adhesive layers 4 is low. For this reason, the amplitude of bending vibrations decreases because of the low Q-value, and the amplitude of the bending vibrations also decreases at the same time because of a reduction in the effect whereby the bending vibrations are excited by the longitudinal vibrations. Consequently, the vibration path Rs of the projection 21 with a small Q-value corresponds to an elliptic vibration in which the longitudinal vibration component is greater than the bending vibration component. Although a force is exerted that pushes the driven body 100 in the radial direction, the force that pushes and rotatably drives the driven body 100 in the tangential direction is small.

Meanwhile, the Q-value increases and the amplitude of longitudinal vibrations becomes wider in cases in which the Shore D hardness of the adhesive layer 4 is 80 HS or greater. The amplitude of the bending vibrations increases because of the high Q-value. Also, the amplitude of the bending vibrations increases with an increase in the amplitude of the longitudinal vibration at the same time because of an increase in the effect whereby the bending vibrations are excited by the longitudinal vibrations. Consequently, the vibration path Rb of the projection 21 with a big Q-value yields adequate vibration amplitude for the longitudinal vibrations and at the same time provides adequate vibration amplitude for the bending vibrations, and also makes it possible to secure the force necessary to push and rotatably drive the driven body 100 in the tangential direction.

It can thus be seen that using an adhesive layer 4 with a high Shore D hardness to ensure the desired Q-value for the piezoelectric actuator 1 is important for obtaining an effect whereby drive efficiency is improved in a piezoelectric actuator 1 in which a plurality of vibration modes is combined to drive a driven body 100.

According to the present embodiment, the following effects can be obtained.
(1) Since the post-hardening Shore D hardness of the adhesive layers 4 is 80 HS or greater, the vibrations of the piezoelectric element 3 are prevented from being absorbed, and the vibrations of the piezoelectric element 3 can be adequately transmitted to the baseboard 2. The vibration loss of the piezoelectric actuator 1 can therefore be reduced.
   In addition, the adhesive agent 41 is a one-component non-solvent type and does not require any mixing, unlike a two-component adhesive agent. Stirring operations can therefore be eliminated, the manufacturing steps can be simplified, and the possibility of air being forced into the adhesive agent 41 by stirring can be eliminated. As a result, it is possible to prevent the piezoelectric elements 3 from being damaged by air expansion, or the service life of the piezoelectric actuator 1 from being reduced by stress concentration during the vibration of the piezoelectric actuator 1 even when heating is performed in the adhesive layer hardening step. Since the adhesive layers 4 can be formed in a uniform manner, variation in the resonance points of longitudinal and bending vibrations can be reduced, and the vibration characteristics of the piezoelectric actuator 1 can be stabilized. In addition, a compounding-related variation among lots is less likely to occur, and the variation in vibration characteristics among a plurality of piezoelectric actuators 1 can therefore be reduced as well.
(2) The adhesive layers 4 can be dried in a shorter time because these adhesive layers 4 are heated in the adhesive layer hardening step. The manufacturing time of the piezoelectric actuators 1 can therefore be reduced. In addition, pressure is applied to the adhesive layers 4 in this step, making it possible to reduce the heating-induced expansion of the adhesive layers 4 in the thickness direction. Furthermore, applying pressure to the adhesive layers 4 in this step causes the baseboard 2 and the electrode layers 31 of the piezoelectric elements 3 (that is, the piezoelectric elements 3) to come into contact with each other along minute irregularities that correspond to each surface roughness. The adhesive layers 4 thereby become interposed between these irregularities. Therefore, the thickness of the adhesive layers 4 becomes dependent on the surface roughness of each adherend surface without being dependent on the coating amount of the adhesive agent 41. The thickness of the adhesive layers 4 can therefore be easily controlled, and variation in the vibration characteristics of the piezoelectric actuator 1 can be reduced.
(3) Since the relative positions of the baseboard 2 and the piezoelectric elements 3 are established by the positioning pins 73 in the positioning step, it is possible to prevent these relative positions from becoming misaligned in the adhesive layer hardening step. It is therefore possible to reduce the variation caused by such positional misalignments in the vibration characteristics of the piezoelectric actuator 1.
(4) Any burrs produced in the manufacturing steps of the baseboard 2 can be removed because the roughness of the adherence surfaces of the piezoelectric elements 3 on the baseboard 2 is adjusted in advance. In addition, the thickness (amount) of the adhesive layers 4 interposed between the baseboard 2 and the piezoelectric elements 3 can be controlled by coordinating the surface roughness of the baseboard 2. Thus, it is possible to further reduce the thickness variation of the adhesive layers 4 and to reduce any variation in the vibration characteristics of the piezoelectric actuator 1.

The present invention is not limited to the above-described embodiment and may include any modifications, improvements, and other changes as long as the objects of the present invention can be attained.

For example, the adhesive layer hardening step is not limited to a procedure in which the adhesive layers 4 were pressed with a pressure tool 7 and heated with a heating tank 61. For example, the hardening step may be performed by conducting heating alone without the use of the pressure tool 7. Alternatively, the adhesive layers 4 may be dried and hardened by being allowed to stand in a pressed state without any heating. Furthermore, the adhesive layers 4 may be dried and hardened by allowing the piezoelectric actuator 1 to stand for a prescribed time without any heating or pressing. At this time, it is possible, for example, to use solely the bottom plate 71 of the pressure tool 7 to position the piezoelectric elements 3 and the baseboard 2.

In the present embodiment, the material of the baseboard 2 was SUS301, but the material of the baseboard 2 is not limited to SUS301. For example, a material whose thermal expansion coefficient is close to the thermal expansion coefficient of the piezoelectric elements 3 is preferably selected in order to reduce residual stress generated by a heating-induced difference in expansion when the adhesive layers 4 are hardened in a heated state in the adhesive layer hardening step. Thus, vibration of the piezoelectric elements 3 can thereby reach the baseboard 2 in a satisfactory manner, and the vibration loss can be further reduced.

The baseboard 2 plays a variety of roles, which include the role of a vibrating body that has adequate elasticity to allow displacement to occur in conjunction with the vibration of the piezoelectric elements 3, the role of a fixing unit for supporting the piezoelectric actuator 1 and fixing it in a prescribed position, the role of a drive component that is pressed against a driven body and caused to drive the driven body, the role of a conductor capable of ensuring electrical conductivity with the piezoelectric elements 3, and the like. Consequently, the baseboard 2 must have sufficient strength as a reinforcing material, sufficient strength for supporting and fixing, adequate elasticity as a vibrating body, and adequate hardness, wear resistance, and other properties needed when the baseboard 2 is pressed against the driven body. In view of this, the material for the baseboard 2 is preferably properly selected to allow all these roles to be satisfied with proper balance.

In the adhesive layer formation step, the spacers 51 were placed on the transfer sheet 5, and the adhesive layer 4 with a prescribed thickness was formed directly on the transfer sheet 5. However, the adhesive layer formation step is not limited to this procedure. For example, it is difficult to prepare spacers 51 with the desired thickness in cases in which an adhesive layer 4 that is thinner than aluminum foil is to be formed. In such cases, the adhesive layer formation step can be provided with an adhesive layer thickness adjustment step for adjusting the thickness of the adhesive layer 4. In the adhesive layer thickness adjustment step, for example, the adhesive layer formed in the adhesive layer formation step is transferred to a thickness-adjusting transfer member having a sheet shape. Then, the thickness of the adhesive layer 4 remaining on the transfer sheet 5 is about half the thickness before the transfer. The thickness of the adhesive layer can be brought to the desired level by appropriately setting the number of the transfers to the thickness-adjusting transfer member. Thus, thinner adhesive layers can be formed. Consequently, since the thinner adhesive layer can be formed, the vibration loss of the piezoelectric vibration body 1 can be further reduced and the vibration decay can be prevented.

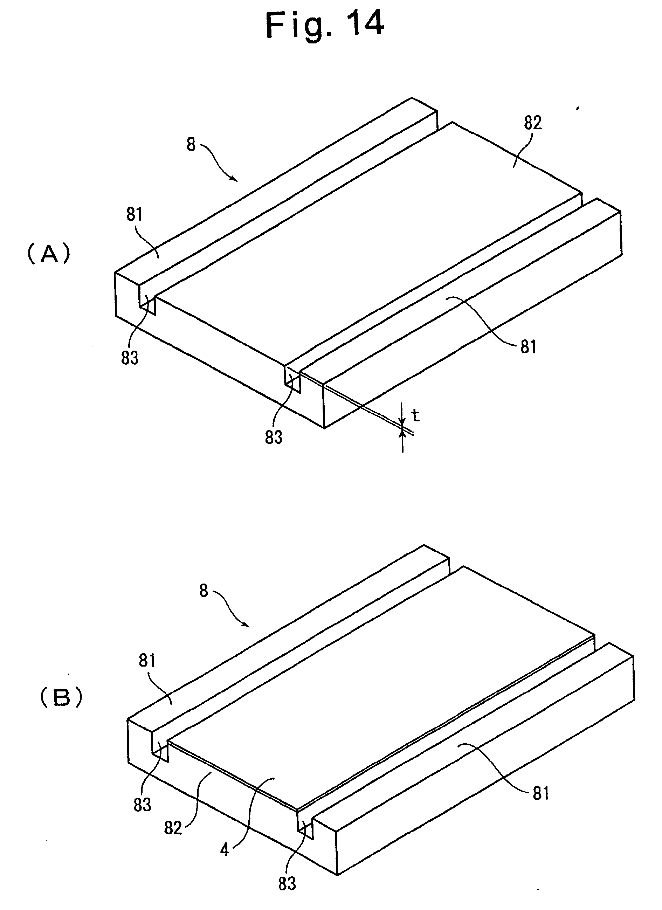

Alternatively, an adhesive layer formation tool 8 such as the one shown in FIGS. 14 can be used.

FIG. 14(A) is a perspective view of the adhesive layer formation tool 8 that can be used in the step for forming the adhesive layers of a piezoelectric actuator, and FIG. 14(B) depicts the adhesive layer 4 formed by the adhesive layer formation tool 8. In FIG. 14(A), the adhesive layer formation tool 8 is formed from stainless steel or another rigid material, and is shaped as a plate. The surface of the adhesive layer formation tool 8 is provided with two slots 83 that run parallel in the lengthwise direction thereof. The surface of the adhesive layer formation tool 8 is divided into three parts by the slots 83. Among these divided parts, the center is an adhesive layer formation portion 82 on which an adhesive layer 4 is formed, and the two sides are guides 81 for uniformly adjusting the thickness of the adhesive layer 4. The surface height of the adhesive layer formation portion 82 is less than the surface height of the guides 81, and the difference *t* in heights is equal to the thickness of the adhesive layer 4 to be formed in the adhesive layer formation step. The difference *t* in heights is about four times the prescribed thickness of the adhesive layer 4 interposed on the piezoelectric actuator 1, and can, for example, be 10 µm.

Adhesive agent 41 is ejected onto the adhesive layer formation portion 82 to form the adhesive layer 4. A flat blade made, for example, of stainless steel or another highly rigid material is subsequently brought into contact such that the side ends of the blade span the space between the guides 81. The blade is moved in the lengthwise direction of the guides 81 while pressed against the guides 81 with a force of about 1.5 kg (1.5 kgf). Thus, the adhesive agent 41 is spread out to a uniform thickness. With this step, the adhesive layer 4 is formed on the adhesive layer formation portion 82 in a thickness that is equal to the difference *t* in heights between the guides 81 and the adhesive layer formation portion 82, as shown in FIG. 14(B). At this time, any excess of the adhesive agent 41 is accumulated in the slots 83, making it possible to form the uniformly thick adhesive layer 4 across the entire adhesive layer formation portion 82.

A polyimide, polyester, or other flexible sheet is then bonded to the top surface of the adhesive layer 4 formed on the adhesive layer formation portion 82. The adhesive layer 4 with about half the thickness (that is, approximately 5 µm) is transferred to the sheet by slowly peeling off this sheet. The adhesive layer 4 with a thickness of about 2.5 µm is transferred to the surface of the piezoelectric element 3 by bonding the surface of the sheet onto which the adhesive layer 4 has been transferred to the piezoelectric element 3 and transferring the adhesive layer 4.

Using such an adhesive layer formation tool 8 allows the thickness of the adhesive layer 4 to be set by using a high-rigidity tool without directly forming the adhesive layer 4 on the transfer sheet 5. Thus, it is possible to set the thickness with high accuracy and to reduce any variation in the thickness of the formed adhesive layer 4. In addition, the adhesive layer 4 between the piezoelectric element 3 and the baseboard 2 can be made thinner because the adhesive layer 4 formed on the adhesive layer formation tool 8 is transferred first to the sheet and then to the piezoelectric element 3.

The material of the adhesive agent 41 is not limited to an epoxy resin used in the present embodiment. Any material may be used as long as the post-hardening Shore D hardness of the material is 80 HS or greater at room temperature, such as an arbitrary thermosetting resin or other synthetic resin. Such a resin allows vibration loss to be reduced beyond the level achievable with a material whose Shore D hardness is less than 80 HS. A steadily stable drive can thereby be obtained even at a low voltage, making it possible, for example, to extend the service life of a battery and to enhance product value for miniature equipment that is not provided with an external power source. In addition, the materials for the baseboard 2, the piezoelectric element 3, the transfer sheet 5, and other elements are not limited to those described in the present embodiment, and can be arbitrarily selected with consideration for the service conditions and the like.

In the piezoelectric element adherence step, the piezoelectric elements 3 was adhered one each of the two sides of the baseboard 2. But the piezoelectric element adherence step is not limited to this procedure. A plurality of piezoelectric elements 3 can be stacked on the board, for example. In this case, the piezoelectric elements 3 with the transferred adhesive layers 4 should be adhered to a separate piezoelectric element. Alternatively, it is also possible to use a device in which the piezoelectric element 3 is adhered on only one side of the baseboard 2.

In the present embodiment, the surface roughness of the baseboard 2 was adjusted with sandpaper. But adjusting the surface roughness of the baseboard 2 is not limited to this procedure. For example, adjustment by grinding or honing can also be used. Alternatively, adjustment of the surface roughness may not be always necessary. For example, the objects of the present invention can be attained when a plate composed of ordinary stainless steel or stainless steel provided in advance with hairlines is used in unaltered state as the material for the baseboard 2 because the adhesive layer 4 of adequate hardness can be formed between the baseboard 2 and the piezoelectric element 3 by using the manufacturing processes involved. In this case, the steps for manufacturing the piezoelectric actuator 1 can thus be simplified by using the plate in unaltered state.

The shape of the piezoelectric actuator 1 is not limited to the one described in the present embodiment. Other possible examples include actuators obtained by stacking a plurality of piezoelectric elements 3 in the above-described manner, actuators in which a plurality of electrodes is formed on the surface of a piezoelectric element 3 by providing slots to the electrode layers 31 of the piezoelectric elements 3, actuators in which the projections 21 of the baseboard 2 have a different shape and are formed at different positions, and other actuators whose parameters are arbitrarily set in accordance with the surface conditions or intended use of the piezoelectric actuator 1.

The piezoelectric actuator 1 has effects such as those describe above, and can therefore be used, for example, in various types of equipment, such as cooling equipment for driving a fan and cooling the required areas. In particular, the piezoelectric actuator 1 can be used in wristwatches, pocket watches, and other analog portable watches because the piezoelectric actuator has low energy loss during vibration and not only is capable of a low-voltage drive but is also designed as a compact and thin device.

The preferred structures, methods, and other conditions needed to work the present invention are disclosed in the above description, but the present invention is not limited by this description. Specifically, the present invention is expressly illustrated and described with reference primarily to prescribed embodiments, but the embodiments described above can be modified in a variety of ways by those skilled in the art in terms of shape, material, number, and other constituent details without departing from the scope of the technical ideas or objects of the present invention.

Consequently, the description that defines the shapes, materials, and other parameters disclosed above is merely an illustrative description designed to aid in understanding the present invention, and does not limit the present invention, for which reason any description that uses names of elements in which these shapes, materials, and other limitations have been completely or partially removed is also included in the present invention.

### INDUSTRIAL APPLICABILITY

The piezoelectric vibration body of the present invention can be used in equipment such as wristwatches, pocket watches, and other analog portable watches in addition to being used in piezoelectric actuators for driving driven bodies by the vibration of piezoelectric elements, and in a cooling equipment and other equipment that uses piezoelectric actuators.

## Claims

1. A piezoelectric vibration body, in which resonance points of a plurality of vibration modes are close to each other, the piezoelectric vibration body comprising a baseboard (2) and a piezoelectric element (3) adhered to one side of said baseboard (2); wherein:
said baseboard (2) is a thin-plate member having a substantially rectangular shape, the substantially rectangular shape having a lengthwise direction, and said piezoelectric element (3) is of a substantially rectangular shape corresponding to the shape of said baseboard (2);
a first projection (21 protrudes in said lengthwise direction from one end of the baseboard (2);
said plurality of vibration modes are a longitudinal-vibration mode, in which longitudinal vibrations occur in a longitudinal direction of the substantially rectangular shape of the baseboard, and a bending-vibration mode, in which bending vibrations occur in a direction substantially orthogonal to the longitudinal vibrations, and
the piezoelectric vibration body is, in use, driven between a resonance frequency of the longitudinal vibrations and a resonance frequency of the bending vibrations;
**characterized in that**:
a second projection (21) is provided, which protrudes in said lengthwise direction from the baseboard (2), the first and second projections being disposed at diagonally opposite ends of the baseboard (2);
an adhesive layer (4) is positioned between said baseboard and said piezoelectric element, said adhesive layer (4) having a hardness that is greater than Shore D hardness 80 HS at room temperature after being hardened;
the bending vibrations are excited by the longitudinal vibrations; and
one of said first and second projections (21) is, in use, vibrated along an elliptical path by the longitudinal and bending vibrations, said one of said projections (21) being able to come into contact with, and to rotationally drive, a driven body (100) by the vibration of the piezoelectric vibration body.

2. The piezoelectric vibration body as recited in claim 1, wherein said adhesive layer (4) is made of a one-component non-solvent type epoxy resin.

3. A piezoelectric actuator arrangement, comprising:
a piezoelectric vibration body, as recited in claim 1 or claim 2, wherein the piezoelectric element (3) is provided with electrodes (31) for receiving a driving voltage;
a driven body (100), and
a source of said driving voltage, said source being arranged to generate a driving voltage capable of driving said piezoelectric vibration body between the two resonance frequencies.

4. The piezoelectric actuator arrangement as recited in claim 3, wherein said adhesive layer (4) is made of a one-component non-solvent type epoxy resin.

## Patentansprüche

1. Piezoelektrischer Vibrator, in dem Resonanzpunkte mehrerer Vibrationsmoden nahe beieinander liegen, wobei der piezoelektrische Vibrator eine Basisplatte (2) und ein piezoelektrisches Element (3) umfasst, das an eine Seite der Basisplatte (2) geklebt ist; wobei
die Basisplatte (2) ein Dünnplattenelement mit einer im Wesentlichen rechteckigen Form ist, wobei die im Wesentlichen rechteckige Form eine Längendimension aufweist, und das piezoelektrische Element (3) eine im Wesentlichen rechteckige Form hat, die der Form der Basisplatte (2) entspricht;
ein erster Fortsatz (21) in der Längsrichtung von einem Ende der Basisplatte (2) absteht;
die mehreren Vibrationsmoden Längsvibrationsmoden, in welchen Längsvibrationen in einer Längsrichtung der im Wesentlichen rechteckigen Form der Basisplatte auftreten, und ein Biegevibrationsmodus sind, in dem Biegevibrationen in einer Richtung im Wesentlichen orthogonal zu den Längsvibrationen auftreten, und
der piezoelektrische Vibrator in Gebrauch zwischen einer Resonanzfrequenz der Längsvibrationen und einer Resonanzfrequenz der Biegevibrationen angetrieben wird;
**dadurch gekennzeichnet, dass**:
ein zweiter Fortsatz (21) vorgesehen ist, der in der Längsrichtung von der Basisplatte (2) absteht, wobei der erste und zweite Fortsatz an diagonal gegenüberliegenden Enden der Basisplatte (2) angeordnet sind;
eine Klebstoffschicht (4) zwischen der Basisplatte und dem piezoelektrischen Element positioniert ist, wobei die Klebstoffschicht (4) eine Härte hat, die nach dem Härten größer ist als Shore D Härte 80 HS bei Raumtemperatur;
die Biegevibrationen durch die Längsvibrationen angeregt werden; und
einer von dem ersten und zweiten Fortsatz (21) in Gebrauch durch die Längs- und Biegevibrationen entlang einer elliptischen Bahn vibriert, wobei der eine der Fortsätze (21) imstande ist, mit einem angetriebenen Körper (100) durch die Vibration des piezoelektrischen Vibrators in Kontakt zu gelangen und diesen in Drehung zu versetzen.

2. Piezoelektrischer Vibrator nach Anspruch 1, wobei die Klebstoffschicht (4) aus einem Einkomponenten-Epoxidharz vom Nicht-Lösemitteltyp besteht.

3. Piezoelektrische Stellgliedanordnung, umfassend:
einen piezoelektrischen Vibrator nach Anspruch 1 oder Anspruch 2, wobei das piezoelektrische Element (3) mit Elektroden (31) zum Empfangen einer Antriebsspannung versehen ist;
einen angetriebenen Körper (100), und
eine Quelle der Antriebsspannung, wobei die Quelle zum Erzeugen einer Antriebsspannung angeordnet ist, die den piezoelektrischen Vibrator zwischen den zwei Resonanzfrequenzen antreiben kann.

4. Piezoelektrische Stellgliedanordnung nach Anspruch 3, wobei die Klebstoffschicht (4) aus einem Einkomponenten-Epoxidharz vom Nicht-Lösemitteltyp besteht.

## Revendications

1. Corps de vibration piézoélectrique, dans lequel des points de résonance d'une pluralité de modes de vibration sont proches les uns des autres, le corps de vibration piézoélectrique comprenant une carte de base (2) et un élément piézoélectrique (3) adhérant sur un côté de ladite carte de base (2) ; dans lequel :
ladite carte de base (2) est un élément de plaque mince ayant une forme essentiellement rectangulaire, la forme essentiellement rectangulaire ayant une direction en longueur, et ledit élément piézoélectrique (3) étant d'une forme essentiellement rectangulaire correspondant à la forme de ladite carte de base (2) ;
une première projection (21) dépassant dans ladite direction en longueur à partir d'une extrémité de la carte de base (2) ;
ladite pluralité des modes de vibration étant un mode de vibration longitudinale, dans lequel des vibrations longitudinales ont lieu dans une direction longitudinale de la forme essentiellement rectangulaire de la carte de base, et un mode de vibration de flexion, dans lequel des vibrations de flexion ont lieu dans une direction essentiellement orthogonale aux vibrations longitudinales ; et
le corps de vibration piézoélectrique étant, lors de l'utilisation, commandé entre une fréquence de résonance des vibrations longitudinales et une fréquence de résonance des vibrations de flexion ;
**caractérisé en ce que** :
une deuxième projection (21) est fournie, laquelle dépasse dans ladite direction en longueur à partir de la carte de base (2), les première et deuxième projections étant disposées à des extrémités diagonalement opposées de la carte de base (2) ;
une couche adhésive (4) étant positionnée entre ladite carte de base et ledit élément piézoélectrique, ladite couche adhésive (4) ayant une dureté qui est supérieure à une dureté Shore de 80 HS à température ambiante après avoir durci ;
les vibrations de flexion étant excitées par les vibrations longitudinales ; et
l'une parmi lesdites première et deuxième projections (21) étant, lors de l'utilisation, soumise à des vibrations le long d'un trajet elliptique grâce aux vibrations longitudinales et de flexion, cette projection desdites projections (21) étant capable d'entrer en contact avec, et d'entraîner de manière rotative, un corps entraîné (100) grâce à la vibration du corps de vibration piézoélectrique.

2. Corps de vibration piézoélectrique tel qu'exposé dans la revendication 1, dans lequel ladite couche adhésive (4) est formée par une résine époxy de type à un composant sans solvant.

3. Dispositif d'actionneur piézoélectrique, comprenant :
un corps de vibration piézoélectrique tel qu'exposé dans la revendication 1 ou la revendication 2, dans lequel l'élément piézoélectrique (3) est muni d'électrodes (31) pour recevoir une tension de commande ;
un corps entraîné (100), et
une source de ladite tension de commande, ladite source étant étudiée pour générer une tension de commande capable de commander ledit corps de vibration piézoélectrique entre les deux fréquences de résonance.

4. Dispositif d'actionneur piézoélectrique tel qu'exposé dans la revendication 3, dans lequel ladite couche adhésive (4) est formée par une résine époxy de type à un composant sans solvant.
